(19) Europäisches Patentamt
European Patent Office
Office européen des brevets

(11) EP 4 648 294 A1

(12) EUROPEAN PATENT APPLICATION

(43) Date of publication:
12.11.2025 Bulletin 2025/46

(21) Application number: 25175063.4

(22) Date of filing: 08.05.2025

(51) International Patent Classification (IPC):
H03M 13/00 (2006.01)    H04L 1/00 (2006.01)
H03M 13/11 (2006.01)    H03M 13/25 (2006.01)

(52) Cooperative Patent Classification (CPC):
H03M 13/6362; H03M 13/6356; H04L 1/0013;
H04L 1/0057; H04L 1/0075; H03M 13/1102;
H03M 13/25; H03M 13/618

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 08.05.2024 US 202463643972 P

(71) Applicant: MEDIATEK INC.
Hsinchu City 30078 (TW)

(72) Inventors:
• HU, Shengquan
San Jose (US)
• LIU, Jianhan
San Jose (US)
• PARE, Jr. Thomas Edward
San Jose (US)

(74) Representative: Hoefer & Partner Patentanwälte
mbB
Pilgersheimer Straße 20
81543 München (DE)

(54) **METHODS AND APPARATUS FOR ENABLING AND SIGNALING 2X1944 LDPC CODES IN NEXT-GENERATION WI-FI**

(57) Techniques pertaining to enabling and signaling 2x1944 low-density parity-check (LDPC) codes in next-generation Wi-Fi in wireless communications are described. A wireless communication apparatus (e.g., a station (STA)) selects a codeword length based at least in part on a number of available bits associated with a data portion in a physical-layer protocol data unit (PPDU). The apparatus generates the PPDU by performing LDPC coding with the selected codeword length. The apparatus then transmits the PPDU in a wireless communication.

FIG. 11

## Description

## CROSS REFERENCE TO RELATED PATENT APPLICATION

The present disclosure is part of a non-provisional patent application claiming the priority benefit of U.S. Provisional Patent Application No. 63/643,972, filed 08 May 2024, the content of which herein being incorporated by reference in its entirety.

## TECHNICAL FIELD

The present disclosure is generally related to wireless communications and, more particularly, to enabling and signaling 2x1944 low-density parity-check (LDPC) codes in next-generation Wi-Fi.

## BACKGROUND

Unless otherwise indicated herein, approaches described in this section are not prior art to the claims listed below and are not admitted as prior art by inclusion in this section.

In wireless communications, such as Wi-Fi (or WiFi) in wireless local area network (WLAN) systems in accordance with the Institute of Electrical and Electronics Engineers (IEEE) 802.11 standards, there are three codeword sizes in currently existing Wi-Fi (e.g., IEEE 802.11n/ac/ax/be), namely: 648, 1296 (= 2x648) and 1944 (= 3x648). The codeword size is chosen based on $N_{avbits}$ and $N_{pld}$. In the present disclosure, $N_{avbits}$ denotes the number of available bits in the minimum number of orthogonal frequency-division multiplexing (OFDM) symbols in which a data field of a packet (e.g., physical-layer protocol data unit (PPDU)) may fit, and $N_{pld}$ denotes the number of bits in the protocol service data unit (PSDU) and Service field). For next-generation Wi-Fi 8 Ultra-High-Reliability (UHR) systems (e.g., IEEE 802.11bn), a longer LDPC with a code word size of 2x1944 (or codeword length 3888) or 4x1944 (or codeword length 7776) were proposed to further enhance LDPC performance. However, at the time of the present disclosure, certain aspects (e.g., codeword length selection for 2x1944 LDPC) have yet to be defined. Therefore, there is a need for a selection method for 2x1944 LDPC in next-generation Wi-Fi.

## SUMMARY

The following summary is illustrative only and is not intended to be limiting in any way. That is, the following summary is provided to introduce concepts, highlights, benefits and advantages of the novel and non-obvious techniques described herein. Select implementations are further described below in the detailed description. Thus, the following summary is not intended to identify essential features of the claimed subject matter, nor is it intended for use in determining the scope of the claimed subject matter.

An objective of the present disclosure is to provide schemes, concepts, designs, techniques, methods and apparatuses pertaining to enabling and signaling 2x1944 (or codeword length 3888) LDPC codes in next-generation Wi-Fi in wireless communications. It is believed that implementations of various schemes proposed herein may address or otherwise alleviate the aforementioned issues.

In one aspect, a method may involve selecting a codeword length based at least in part on a number of available bits associated with a data portion in a physical-layer protocol data unit (PPDU). The method may also involve generating the PPDU by performing LDPC coding with the selected codeword length. The method may further involve transmitting the PPDU in a wireless communication.

In another aspect, an apparatus may include a transceiver configured to communicate wirelessly and a processor coupled to the transceiver. The processor may select a codeword length based at least in part on a number of available bits associated with a data portion in a PPDU. The processor may also generate the PPDU by performing LDPC coding with the selected codeword length. The processor may further transmit, via the transceiver, the PPDU in a wireless communication.

It is noteworthy that, although description provided herein may be in the context of certain radio access technologies, networks and network topologies such as, Wi-Fi, the proposed concepts, schemes and any variation(s)/derivative(s) thereof may be implemented in, for and by other types of radio access technologies, networks and network topologies such as, for example and without limitation, Bluetooth, ZigBee, 5th Generation (5G)/New Radio (NR), Long-Term Evolution (LTE), LTE-Advanced, LTE-Advanced Pro, Internet-of-Things (IoT), Industrial IoT (IIoT) and narrowband IoT (NB-IoT). Thus, the scope of the present disclosure is not limited to the examples described herein.

## BRIEF DESCRIPTION OF THE DRAWINGS

The accompanying drawings are included to provide a further understanding of the disclosure and are incorporated in and constitute a part of the present disclosure. The drawings illustrate implementations of the disclosure and, together with the description, serve to explain the principles of the disclosure. It is appreciable that the drawings are not necessarily in scale as some components may be shown to be out of proportion than the size in actual implementation to clearly illustrate the concept of the present disclosure.

FIG. 1 is a diagram of an example network environment in which various solutions and schemes in accordance with the present disclosure may be implemented.

FIG. 2 is a diagram of an example design under a proposed scheme in accordance with the present disclosure.

FIG. 3 is a diagram of an example design under a proposed scheme in accordance with the present disclosure.

FIG. 4 is a diagram of an example design under a proposed scheme in accordance with the present disclosure.

FIG. 5 is a diagram of an example design under a proposed scheme in accordance with the present disclosure.

FIG. 6 is a diagram of an example design under a proposed scheme in accordance with the present disclosure.

FIG. 7 is a diagram of an example design under a proposed scheme in accordance with the present disclosure.

FIG. 8 is a diagram of an example design under a proposed scheme in accordance with the present disclosure.

FIG. 9 is a diagram of an example design under a proposed scheme in accordance with the present disclosure.

FIG. 10 is a diagram of an example design under a proposed scheme in accordance with the present disclosure.

FIG. 11 is a diagram of an example design under a proposed scheme in accordance with the present disclosure.

FIG. 12 is a block diagram of an example communication system under a proposed scheme in accordance with the present disclosure.

FIG. 13 is a flowchart of an example process under a proposed scheme in accordance with the present disclosure.

## DETAILED DESCRIPTION OF PREFERRED EMBODIMENTS

Detailed embodiments and implementations of the claimed subject matters are disclosed herein. However, it shall be understood that the disclosed embodiments and implementations are merely illustrative of the claimed subject matters which may be embodied in various forms. The present disclosure may, however, be embodied in many different forms and should not be construed as limited to the exemplary embodiments and implementations set forth herein. Rather, these exemplary embodiments and implementations are provided so that description of the present disclosure is thorough and complete and will fully convey the scope of the present disclosure to those skilled in the art. In the description below, details of well-known features and techniques may be omitted to avoid unnecessarily obscuring the presented embodiments and implementations.

*Overview*

At the time of the present disclosure, certain aspects (e.g., codeword length selection for 2x1944 (or codeword length 3888) LDPC, signaling method to enable 2x1944 LDPC, minimum resource unit (RU) and multi-RU (MRU) size to support 2x LDPC, packet extension (PE) requirement for 2x LDPC (or codeword length 3888 LDPC), and physical layer (PHY) capability indication for longer LDPC operation) have yet to be defined. Therefore, there is a need for a solution of enabling and signaling 2x1944 LDPC codes in next-generation Wi-Fi.

Implementations in accordance with the present disclosure relate to various techniques, methods, schemes and/or solutions pertaining to selecting and signaling 2x1944 LDPC codes in next-generation Wi-Fi in wireless communications. According to the present disclosure, a number of possible solutions may be implemented separately or jointly. That is, although these possible solutions may be described below separately, two or more of these possible solutions may be implemented in one combination or another.

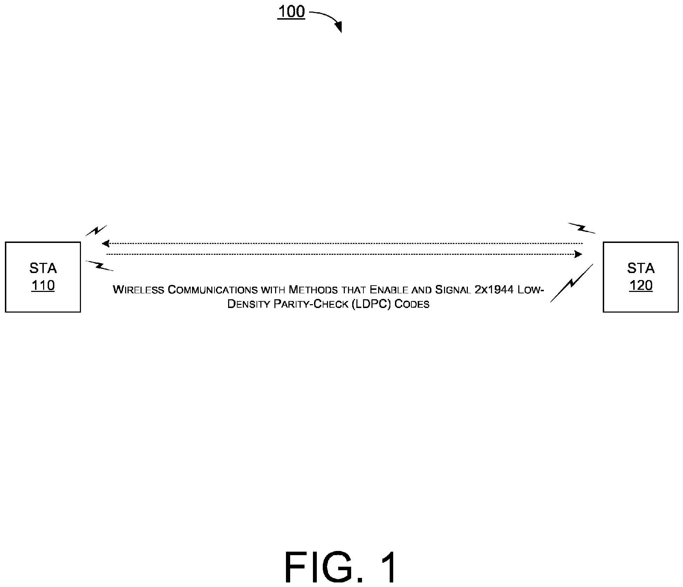

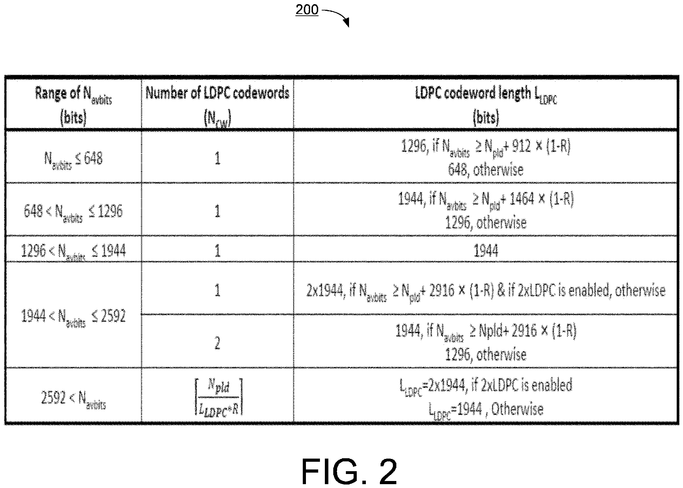

FIG. 1 illustrates an example network environment 100 in which various solutions and schemes in accordance with the present disclosure may be implemented. FIG. 2 ~ FIG. 13 illustrate examples of implementation of various proposed schemes in network environment 100 in accordance with the present disclosure. The following description of various proposed schemes is provided with reference to FIG. 1 ~ FIG.13.

Referring to FIG. 1, network environment 100 may involve at least a station (STA) 110 communicating wirelessly with a STA 120. Either of STA 110 and STA 120 may function as an access point (AP) STA or, alternatively, a non-AP STA. In some cases, STA 110 and STA 120 may be associated with a basic service set (BSS) in accordance with one or more IEEE 802.11 standards (e.g., IEEE 802.11bn and future-developed standards). Each of STA 110 and STA 120 may be configured to communicate with each other by utilizing the selecting and signaling 2x1944 LDPC codes in next-generation Wi-Fi in accordance with various proposed schemes described below. It is noteworthy that, while the various proposed schemes may be individually or separately described below, in actual implementations some or all of the proposed schemes may be utilized or otherwise implemented jointly. Of course, each of the proposed schemes may be utilized or otherwise implemented individually or separately.

FIG. 2 illustrates an example design 200 under a proposed scheme (Option-1) in accordance with the present disclosure. Referring to FIG. 2, under the proposed scheme, for smaller $N_{avbits}$ and $N_{pld}$, the same codeword length selection for existing 1xLDPC (e.g., codeword length 648, 1296 or 1944) may be kept. When both $N_{avbits}$ and $N_{pld}$ become larger (e.g., $N_{avbits} > 2592$) and the codeword length is selected for a number of codewords ($N_{cw}$) greater than or equal to 2 ($N_{cw} \geq 2$),

the codeword length of 2x1944 (or 3888) may be selected if 2xLDPC subfield is set to 1 (e.g., enabled, it means 2xLDPC mode is enabled), otherwise, the codeword length of 1944 may be selected. Moreover, for $1944 < N_{avbits} \leq 2592$ and for $N_{cw} = 2$, the codeword length of 1944 may be selected if $N_{avbits} \geq N_{pld} + 2916 \times (1 - R)$, where R denotes the coding rate; otherwise, the codeword length of 1296 may be selected.

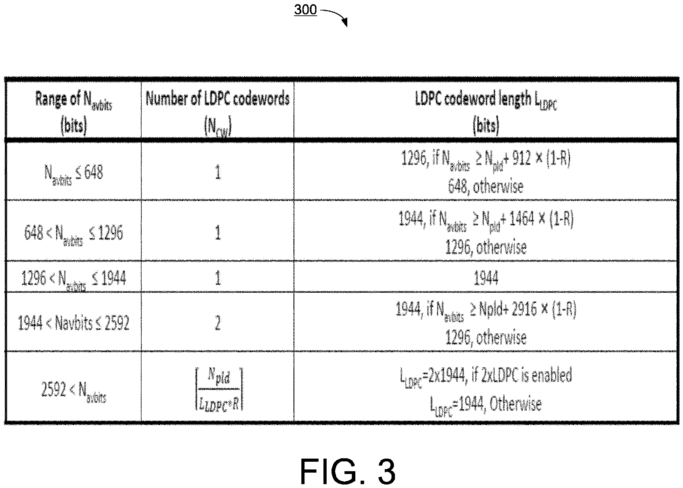

FIG. 3 illustrates an example design 300 under a proposed scheme (Option-2) in accordance with the present disclosure. Referring to FIG. 3, under the proposed scheme, for smaller $N_{avbits}$ and $N_{pld}$, the same codeword length selection for existing 1xLDPC may be kept. When $N_{avbits}$ and $N_{pld}$ become larger (e.g., $N_{avbits} > 2592$) and the codeword length is selected for a number of codewords ($N_{cw}$) greater than 2 ($N_{cw} > 2$), the codeword length of 2x1944 (or 3888) may be selected if 2xLDPC subfield is set to 1 (e.g., enabled), otherwise, the codeword length of 1944 may be selected. Moreover, for $1944 < N_{avbits} \leq 2592$, the codeword length of 1944 may be selected if $N_{avbits} \geq N_{pld} + 2916 \times (1 - R)$, where R denotes the coding rate; otherwise, the codeword length of 1296 may be selected.

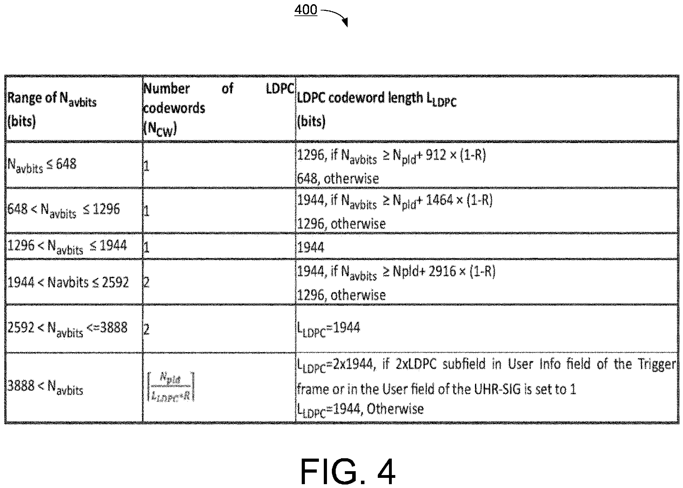

FIG. 4 illustrates an example design 400 under a proposed scheme (Option-3) in accordance with the present disclosure. Referring to FIG. 4, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$ greater than 3888 ($N_{avbits} > 3888$), Ncw is $\left\lceil \frac{N_{pld}}{L_{LDPC} * R} \right\rceil$ and the codeword length of 2x1944 may be selected if 2x1944 LDPC subfield is set to 1 (e.g., enabled), otherwise, the codeword length of 1944 may be selected. Referring to FIG. 4, when $N_{avbits}$ is greater than 2592 and less than or equal to 3888, the codeword length of 1944 may be selected and Ncw is 2. In the present disclosure, the term "2x1944 LDPC being enabled" means that the transmitter supports to use 2x1944 LDPC to perform LDPC coding for generating a PPDU and 2xLDPC subfield is set to 1. Moreover, for $1944 < N_{avbits} \leq 2592$, the codeword length of 1944 may be selected if $N_{avbits} \geq N_{pld} + 2916 \times (1 - R)$, where R denotes the coding rate; otherwise, the codeword length of 1296 may be selected. In an alternative embodiment, when $N_{avbits}$ and $N_{pld}$ become larger with $N_{avbits}$ greater than or equal to 3888, the codeword length of 2x1944 may be selected if 2x1944 LDPC subfield is set to 1 (e.g., enabled), otherwise, the codeword length of 1944 may be selected. The 2xLDPC subfield may be in User Info field of the Trigger frame or in the User field of the UHR-SIG.

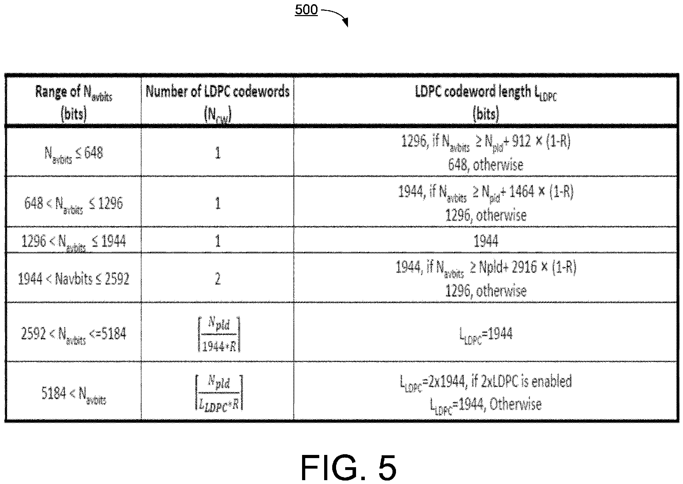

FIG. 5 illustrates an example design 500 under a proposed scheme (Option-3a) in accordance with the present disclosure. Referring to FIG. 5, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$

greater than 5184 ($N_{avbits} > 5184$), the codeword length of 2x1944 (or 3888) may be selected if 2xLDPC is enabled, otherwise, the codeword length of 1944 may be selected. Additionally, for $2592 < N_{avbits} \leq 5184$, the codeword length of 1944 may be selected. Moreover, for $1944 < N_{avbits} \leq 2592$, the codeword length of 1944 may be selected if $N_{avbits} \geq N_{pld} + 2916 \times (1 - R)$, where R denotes the coding rate; otherwise, the codeword length of 1296 may be selected. In an alternative embodiment, when $N_{avbits}$ and $N_{pld}$ become larger with $N_{avbits}$ greater than or equal to 5184, the codeword length of 2x1944 (or 3888) may be selected if 2xLDPC is enabled, otherwise, the codeword length of 1944 may be selected.

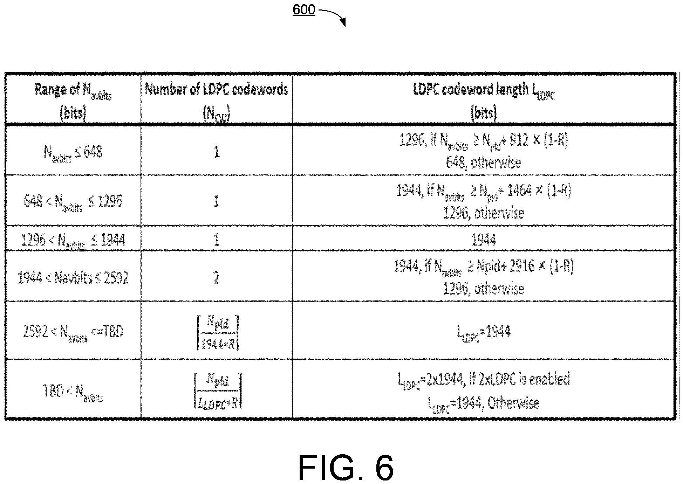

FIG. 6 illustrates an example design 600 under a proposed scheme (Option-3b) in accordance with the present disclosure. Referring to FIG. 6, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$ greater than a to-be-defined (TBD) number that is up to further optimization ($N_{avbits} > TBD$), the codeword length of 2x1944 (or 3888) may be selected if 2xLDPC is enabled, otherwise, the codeword length of 1944 may be selected. Additionally, for $2592 < N_{avbits} \leq TBD$, the codeword length of 1944 may be selected. Moreover, for $1944 < N_{avbits} \leq 2592$, the codeword length of 1944 may be selected if $N_{avbits} \geq N_{pld} + 2916 \times (1 - R)$, where R denotes the coding rate; otherwise, the codeword length of 1296 may be selected.

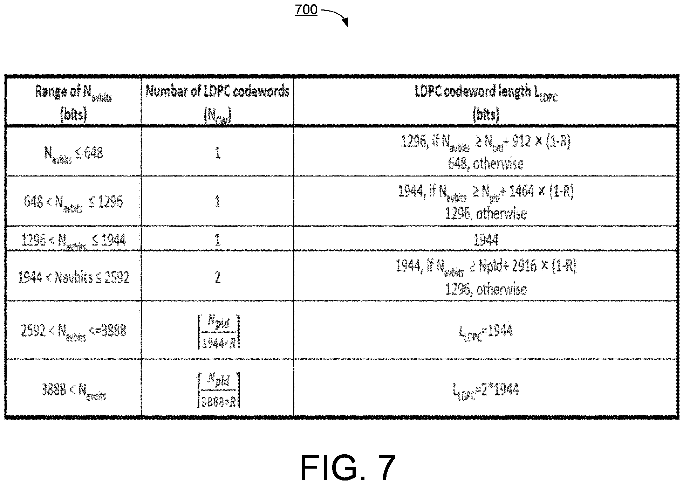

FIG. 7 illustrates an example design 700 under a proposed scheme (Option-4) in accordance with the present disclosure. Referring to FIG. 7, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$ greater than 3888 ($N_{avbits} > 3888$), the codeword length of 2x1944 (or 3888) may be selected. Additionally, for $2592 < N_{avbits} \leq 3888$, the codeword length of 1944 may be selected. Moreover, for $1944 < N_{avbits} \leq 2592$, the codeword length of 1944 may be selected if $N_{avbits} \geq N_{pld} + 2916 \times (1 - R)$, where R denotes the coding rate; otherwise, the codeword length of 1296 may be selected. In Option-4, when determining the codeword length, it is not needed to consider if 2x1944 LDPC subfield is set to 1 (e.g., enabled). In an alternative embodiment, when $N_{avbits}$ and $N_{pld}$ become larger with $N_{avbits}$ greater than or equal to 3888, the codeword length of 2x1944 (or 3888) may be selected.

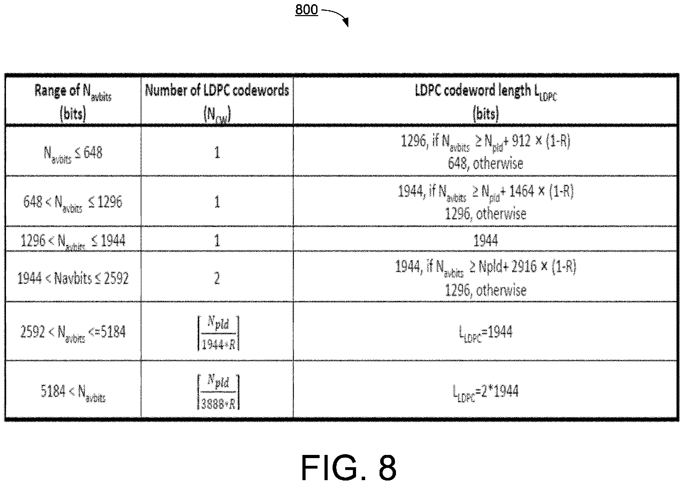

FIG. 8 illustrates an example design 800 under a proposed scheme (Option-4a) in accordance with the present disclosure. Referring to FIG. 8, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$ greater than 5184 ($N_{avbits} > 5184$), the codeword length of 2x1944 (or 3888) may be selected. Additionally, for $2592 < N_{avbits} \leq 5184$, the codeword length of 1944 may be selected. Moreover, for $1944 < N_{avbits} \leq 2592$, the code-

word length of 1944 may be selected if $N_{avbits} \geq N_{pld}$ + 2916 x (1 - R), where R denotes the coding rate; otherwise, the codeword length of 1296 may be selected. In an alternative embodiment, when $N_{avbits}$ and $N_{pld}$ become larger with $N_{avbits}$ greater than or equal to 5184, the codeword length of 2x1944 (or 3888) may be selected.

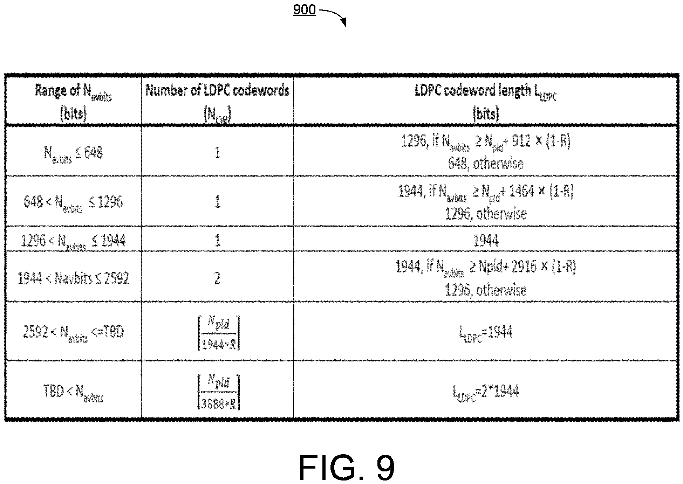

FIG. 9 illustrates an example design 900 under a proposed scheme (Option-4b) in accordance with the present disclosure. Referring to FIG. 9, under the proposed scheme, for smaller $N_{avbits}$ and $N_{pld}$, the same codeword length selection for existing 1xLDPC may be kept. When $N_{avbits}$ and $N_{pld}$ become larger with $N_{avbits}$ greater than a TBD number that is up to further optimization ($N_{avbits}$ > TBD), the codeword length of 2x1944 (or 3888) may be selected. Additionally, for 2592 < $N_{avbits} \leq$ TBD, the codeword length of 1944 may be selected. Moreover, for 1944 < $N_{avbits} \leq$ 2592, the codeword length of 1944 may be selected if $N_{avbits} \geq N_{pld}$ + 2916 x (1 - R), where R denotes the coding rate; otherwise, the codeword length of 1296 may be selected.

Under a proposed scheme (Option-5) in accordance with the present disclosure with respect to LDPC codeword length selection, a transmitter may decide whether to use 1xLDPC or 2xLDPC. The LDPC mode (1x or 2x) may be indicated in the User Specific field of a PPDU.

Under a proposed scheme (Option-6) in accordance with the present disclosure with respect to a minimum RU size for 2xLDPC, a longer 2xLDPC may be mainly used for larger packets and higher throughputs. To reduce the complexity in implementation and to reduce the costs for devices operating in the 2.4GHz band and/or 5GHz band, the minimum RU size may be limited for 2xLDPC operations. For instance, the minimum RU/MRU size may be 484 tones (RU/MRU $\geq$ 484). Alternatively, the minimum RU/MRU size may be 996 tones (RU/MRU $\geq$ 996).

Under a proposed scheme (Option-7) in accordance with the present disclosure with respect to packet extension for 2xLDPC, as some studies show that 2x1944 LDPC requires 1.5 times (1.5x) iterations to achieve a better performance gain compared to 1xLDPC, decoding with respect to 2xLDPC may be implemented either through parallel processing (e.g., with double hardware decoder engines) or by increasing a system clock to speed up. To relax a latency requirement, the packet extension (PE) duration may be fixed with 20 microseconds (20μs) for the PPDU using 2xLDPC. Therefore, PE (Packet Extension) field duration (T_PE) in the PPDU is fixed to 20us when the selected LDPC codeword length is 3888 and the 2xLDPC subfield in the PPDU is set to 1. In some embodiments, a Nominal Packet Padding in the PPDU is fixed to 20us when the selected LDPC codeword length is 3888 and the 2xLDPC subfield in the PPDU is set to 1.

Under a proposed scheme (Option-8) in accordance with the present disclosure with respect to the notification of the support capability of 2*LDPC (which is a new PHY feature for IEEE 802.11bn), certain information may be added to the PHY Capabilities Info field of a PPDU to allow devices having the flexibility to choose 1xLDPC or 2xLDPC. For instance, the new information added in the PHY Capabilities Info field may indicate the apparatus acting as a transmitter supports 2x1944 LDPC encoding and/or the apparatus acting as a receiver supports 2x1944 LDPC decoding.

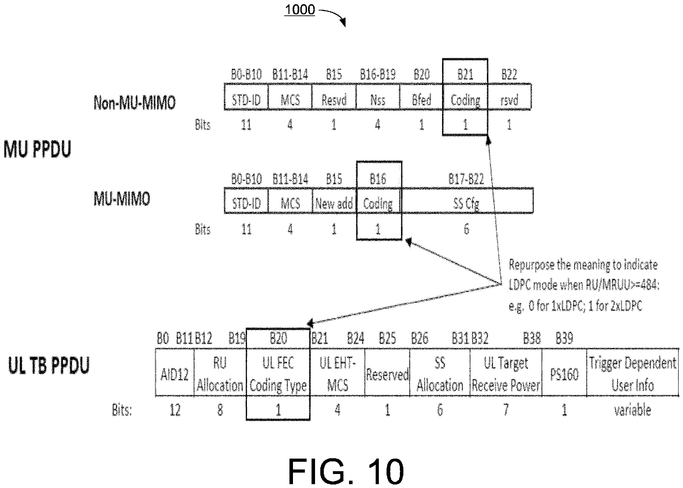

FIG. 10 illustrates an example design 1000 under a proposed scheme (Option-1) with respect to signaling for 2xLDPC in accordance with the present disclosure. Referring to FIG. 10, under the proposed scheme, one bit in the User Specific field of a PPDU may be utilized to indicate the LDPC mode of the PPDU as either 1xLDPC or 2xLDPC (e.g., to indicate whether 2xLDPC is enabled or disabled). For instance, a value of "1" may indicate 2xLDPC is enabled (or that the LDPC mode is 2xLDPC) in the PPDU and a value of "0" may indicate 2xLDPC is disabled in the PPDU, or vice versa. In case that 2xLDPC is limited for RU/MRU $\geq$ 484, a bit used for "Coding" or "UL FEC Coding Type" in the User Specific field may be repurposed to indicate the LDPC mode of the PPDU as either 1xLDPC or 2xLDPC. For instance, a value of "0" may indicate 1xLDPC and a value of "1" may indicate 2xLDPC, or vice versa.

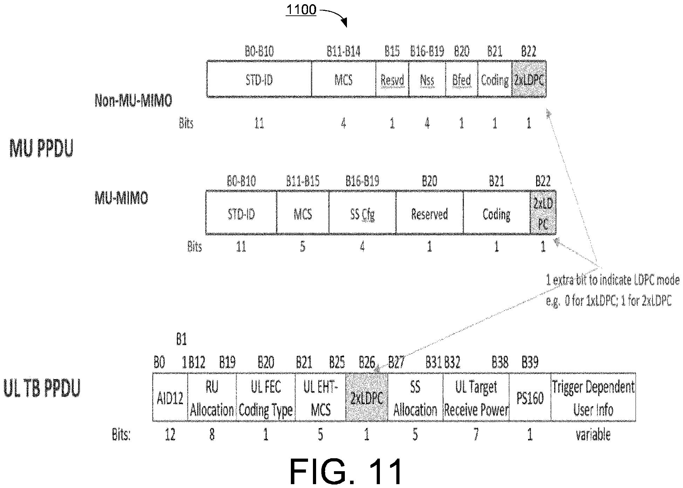

FIG. 11 illustrates an example design 1100 under a proposed scheme (Option-2) with respect to signaling for 2xLDPC in accordance with the present disclosure. Referring to FIG. 11, under the proposed scheme, one bit may be utilized to indicate the LDPC mode of the PPDU as either 1xLDPC or 2xLDPC (e.g., to indicate whether 2xLDPC is enabled or disabled). For instance, a value of "1" may indicate 2xLDPC is enabled (or that the LDPC mode is 1xLDPC) in the PPDU and a value of "0" may indicate 2xLDPC is disabled in the PPDU, or vice versa. Under the proposed scheme, such a bit may be a new bit or extra bit added in the User Specific field to indicate the 2xLDPC mode (e.g., bit 22 (B22)), and there may be a total of 23 bits in the User Specific field. Moreover, under the proposed scheme, it may be assumed that there is no RU size limitation for using 2xLDPC.

Under a proposed scheme (Option-3) in accordance with the present disclosure with respect to signaling for 2xLDPC, there may be no explicit LDPC mode indication and, as such, whether or not a transmission of a PPDU is with 1xLDPC or 2xLDPC may be determined by the codeword length selection based on example design 700 (Option-4), example design 800 (Option-4a) or example design 900 (Option-4b) described above.

Under a proposed scheme in accordance with the present disclosure with respect to 2xLDPC for uplink (UL) trigger-based (TB) PPDU, an UL TB PPDU for users (e.g., STAs) with mixed 1xLDPC and 2xLDPC scheduling may introduce decoding complexity at an AP receiver side. For instance, the complexity may pertain to decoding latency being different for 1xLDPC and 2xLDPC, the requirement of the number of iterations may be different for 1xLDPC and 2xLDPC, and memory and hardware engine sharing may be complicated, among other concerns. Thus, under the proposed scheme, UL TB PPDU for STAs may be limited to all using 1xLDPC or all using 2xLDPC so as to minimize or otherwise reduce the decoding complexity.

### *Illustrative Implementations*

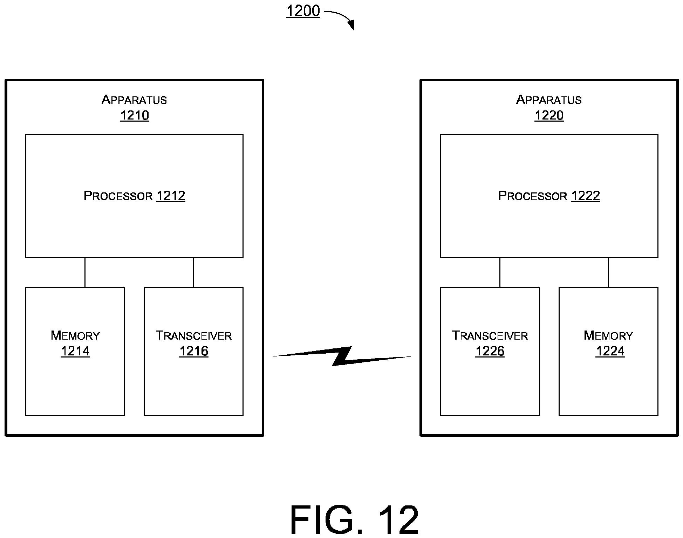

FIG. 12 illustrates an example system 1200 having at least an example apparatus 1210 and an example apparatus 1220 in accordance with an implementation of the present disclosure. Each of apparatus 1210 and apparatus 1220 may perform various functions to implement schemes, techniques, processes and methods described herein pertaining to enabling and signaling 2x1944 LDPC codes in next-generation Wi-Fi in wireless communications including the various schemes described above with respect to various proposed designs, concepts, schemes, systems and methods described above as well as processes described below. For instance, apparatus 1210 may be implemented in STA 110 and apparatus 1220 may be implemented in STA 120, or vice versa.

Each of apparatus 1210 and apparatus 1220 may be a part of an electronic apparatus, which may be a non-AP STA or an AP STA, such as a portable or mobile apparatus, a wearable apparatus, a wireless communication apparatus or a computing apparatus. When implemented in a STA, each of apparatus 1210 and apparatus 1220 may be implemented in a smartphone, a smart watch, a personal digital assistant, a digital camera, or a computing equipment such as a tablet computer, a laptop computer or a notebook computer. Each of apparatus 1210 and apparatus 1220 may also be a part of a machine type apparatus, which may be an IoT apparatus such as an immobile or a stationary apparatus, a home apparatus, a wire communication apparatus or a computing apparatus. For instance, each of apparatus 1210 and apparatus 1220 may be implemented in a smart thermostat, a smart fridge, a smart door lock, a wireless speaker or a home control center. When implemented in or as a network apparatus, apparatus 1210 and/or apparatus 1220 may be implemented in a network node, such as an AP in a WLAN.

In some implementations, each of apparatus 1210 and apparatus 1220 may be implemented in the form of one or more integrated-circuit (IC) chips such as, for example and without limitation, one or more single-core processors, one or more multicore processors, one or more reduced-instruction set computing (RISC) processors, or one or more complex-instruction-set-computing (CISC) processors. In the various schemes described above, each of apparatus 1210 and apparatus 1220 may be implemented in or as a STA or an AP. Each of apparatus 1210 and apparatus 1220 may include at least some of those components shown in FIG. 12 such as a processor 1212 and a processor 1222, respectively.

Each of apparatus 1210 and apparatus 1220 may further include one or more other components not pertinent to the proposed scheme of the present disclosure (e.g., internal power supply, display device and/or user interface device), and thus, such component(s) of apparatus 1210 and apparatus 1220 are neither shown in FIG. 12 nor described below in the interest of simplicity and brevity.

In one aspect, each of processor 1212 and processor 1222 may be implemented in the form of one or more single-core processors, one or more multicore processors, one or more RISC processors or one or more CISC processors. That is, even though a singular term "a processor" is used herein to refer to processor 1212 and processor 1222, each of processor 1212 and processor 1222 may include multiple processors in some implementations and a single processor in other implementations in accordance with the present disclosure. In another aspect, each of processor 1212 and processor 1222 may be implemented in the form of hardware (and, optionally, firmware) with electronic components including, for example and without limitation, one or more transistors, one or more diodes, one or more capacitors, one or more resistors, one or more inductors, one or more memristors and/or one or more varactors that are configured and arranged to achieve specific purposes in accordance with the present disclosure. In other words, in at least some implementations, each of processor 1212 and processor 1222 is a special-purpose machine specifically designed, arranged and configured to perform specific tasks including those pertaining to enabling and signaling 2x1944 LDPC codes in next-generation Wi-Fi in wireless communications in accordance with various implementations of the present disclosure.

In some implementations, apparatus 1210 may also include a transceiver 1216 coupled to processor 1212. Transceiver 1216 may include a transmitter capable of wirelessly transmitting and a receiver capable of wirelessly receiving data. In some implementations, apparatus 1220 may also include a transceiver 1226 coupled to processor 1222. Transceiver 1226 may include a transmitter capable of wirelessly transmitting and a receiver capable of wirelessly receiving data. It is noteworthy that, although transceiver 1216 and transceiver 1226 are illustrated as being external to and separate from processor 1212 and processor 1222, respectively, in some implementations, transceiver 1216 may be an integral part of processor 1212 as a system on chip (SoC), and transceiver 1226 may be an integral part of processor 1222 as a SoC.

In some implementations, apparatus 1210 may further include a memory 1214 coupled to processor 1212 and capable of being accessed by processor 1212 and storing data therein. In some implementations, apparatus 1220 may further include a memory 1224 coupled to processor 1222 and capable of being accessed by processor 1222 and storing data therein. Each of memory 1214 and memory 1224 may include a type of random-access memory (RAM) such as dynamic RAM (DRAM), static RAM (SRAM), thyristor RAM (T-RAM) and/or zero-capacitor RAM (Z-RAM). Alternatively, or additionally, each of memory 1214 and memory 1224 may include a type of read-only memory (ROM) such as mask ROM, programmable ROM (PROM), erasable programmable ROM (EPROM) and/or electrically erasable programmable ROM (EEPROM). Alternatively, or additionally, each of memory 1214 and memory 1224 may include a type of non-volatile random-access memory (NVRAM) such as flash memory, solid-state memory, ferroelectric RAM (FeRAM), magnetoresistive RAM (MRAM) and/or phase-change memory.

Each of apparatus 1210 and apparatus 1220 may be a communication entity capable of communicating with each other using various proposed schemes in accordance with the present disclosure. For illustrative purposes and without limitation, a description of capabilities of apparatus 1210, as STA 110, and apparatus 1220, as STA 120, is provided below in the context of example process 1300. It is noteworthy that, although a detailed description of capabilities, functionalities and/or technical features of apparatus 1220 is provided below, the same may be applied to apparatus 1210 although a detailed description thereof is not provided solely in the interest of brevity. It is also noteworthy that, although the example implementations described below are provided in the context of WLAN, the same may be implemented in other types of networks.

### Illustrative Processes

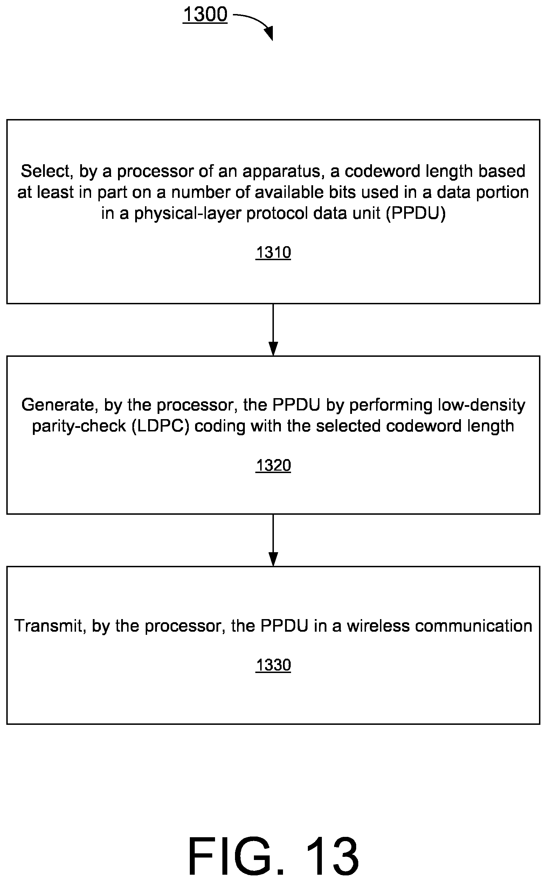

FIG. 13 illustrates an example process 1300 in accordance with an implementation of the present disclosure. Process 1300 may represent an aspect of implementing various proposed designs, concepts, schemes, systems and methods described above. More specifically, process 1300 may represent an aspect of the proposed concepts and schemes pertaining to enabling and signaling 2x1944 LDPC codes in next-generation Wi-Fi in wireless communications in accordance with the present disclosure. Process 1300 may include one or more operations, actions, or functions as illustrated by one or more of blocks such as 1310, 1320 and 1330. Although illustrated as discrete blocks, various blocks of process 1300 may be divided into additional blocks, combined into fewer blocks, or eliminated, depending on the desired implementation. Moreover, the blocks/sub-blocks of process 1300 may be executed in the order shown in FIG. 13 or, alternatively, in a different order. Furthermore, one or more of the blocks/sub-blocks of process 1300 may be executed repeatedly or iteratively. Process 1300 may be implemented by or in apparatus 1210 and apparatus 1220 as well as any variations thereof. Solely for illustrative purposes and without limiting the scope, process 1300 is described below in the context of apparatus 1210 implemented in or as STA 110 functioning as a non-AP STA or an AP STA and apparatus 1220 implemented in or as STA 120 functioning as an AP STA or a non-AP STA of a wireless network such as a WLAN in network environment 100 in accordance with one or more of IEEE 802.11 standards. Process 1300 may begin at block 1310.

At 1310, process 1300 may involve processor 1212 of apparatus 1210 selecting a codeword length based at least in part on a number of available bits associated with a data portion in a PPDU (e.g., $N_{avbits}$, which is the number of available bits in the minimum number of OFDM symbols in which a data portion of the PPDU may fit). Process 1300 may proceed from 1310 to 1320.

At 1320, process 1300 may involve processor 1212 generating the PPDU by performing LDPC coding with the selected codeword length. Process 1300 may proceed from 1320 to 1330.

At 1330, process 1300 may involve processor 1212 transmitting, via transceiver 1216, the PPDU in a wireless communication (e.g., to apparatus 1220 as STA 120).

In some implementations, in selecting, process 1300 may involve processor 1212 selecting the codeword length also based on whether a 2xLDPC subfield in the PPDU is set to 0 or 1, wherein 2xLDPC subfield set to be 1 means that a 2xLDPC mode is enabled for the PPDU.

In some implementations, in selecting, process 1300 may involve processor 1212 selecting the codeword length to be 3888 responsive to the number of available bits being greater than 3888 and the 2xLDPC subfield being set to 1. Alternatively, in selecting, process 1300 may involve processor 1212 selecting the codeword length to be 1944 responsive to the number of available bits being greater than 3888 and the 2xLDPC subfield being set to 0. Still alternatively, in selecting, process 1300 may involve processor 1212 selecting the codeword length to be 1944 responsive to the number of available bits being less than or equal to 3888 and greater than 2592.

In some implementations, information in a PHY Capabilities Information field of the PPDU may indicate that apparatus 1210 supports the use of 2x1944 LDPC in performing LDPC encoding when apparatus 1210 (or transceiver 1216) acts as a transmitter.

In some implementations, information in a PHY Capabilities Information field of the PPDU may indicate that apparatus 1210 supports the use of 2x1944 LDPC in performing LDPC decoding when apparatus 1210 (or transceiver 1216) acts as a receiver.

In some implementations, information in a PHY Capabilities Information field of the PPDU may indicate that apparatus 1210 supports the use of 2x1944 LDPC in performing LDPC encoding when apparatus 1210 (or transceiver 1216) acts as a transmitter and supports the use of 2x1944 LDPC in performing LDPC decoding when apparatus 1210 (or transceiver 1216) acts as a receiver.

In some implementations, a new or extra bit added in a User Specific field of the PPDU may indicate whether a 2xLDPC mode is enabled or disabled without RU size limitation. In some implementations, with the new or extra bit added, there may be a total of 23 bits in the User Specific field. In some implementations, the new or extra bit may be bit 22 (B22) in the User Specific field.

In some implementations, a Nominal Packet Padding in the PPDU may be fixed to 20us when the selected LDPC codeword length is 3888 and the 2xLDPC subfield in the PPDU is set to 1. In some implementations, a PE (Packet Extension) field duration (T_PE) in the PPDU may be fixed to 20us when the selected LDPC codeword length is 3888 and the 2xLDPC subfield in the PPDU is set to 1.

### Additional Notes

The herein-described subject matter sometimes illustrates different components contained within, or connected with, different other components. It is to be understood that such depicted architectures are merely examples, and that in fact many other architectures can be implemented which achieve the same functionality. In a conceptual sense, any arrangement of components to achieve the same functionality is effectively "associated" such that the desired functionality is achieved. Hence, any two components herein combined to achieve a particular functionality can be seen as "associated with" each other such that the desired functionality is achieved, irrespective of architectures or intermedial components. Likewise, any two components so associated can also be viewed as being "operably connected", or "operably coupled", to each other to achieve the desired functionality, and any two components capable of being so associated can also be viewed as being "operably couplable", to each other to achieve the desired functionality. Specific examples of operably couplable include but are not limited to physically mateable and/or physically interacting components and/or wirelessly interactable and/or wirelessly interacting components and/or logically interacting and/or logically interactable components.

Further, with respect to the use of substantially any plural and/or singular terms herein, those having skill in the art can translate from the plural to the singular and/or from the singular to the plural as is appropriate to the context and/or application. The various singular/plural permutations may be expressly set forth herein for sake of clarity.

Moreover, it will be understood by those skilled in the art that, in general, terms used herein, and especially in the appended claims, e.g., bodies of the appended claims, are generally intended as "open" terms, e.g., the term "including" should be interpreted as "including but not limited to," the term "having" should be interpreted as "having at least," the term "includes" should be interpreted as "includes but is not limited to," etc. It will be further understood by those within the art that if a specific number of an introduced claim recitation is intended, such an intent will be explicitly recited in the claim, and in the absence of such recitation no such intent is present. For example, as an aid to understanding, the following appended claims may contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to implementations containing only one such recitation, even when the same claim includes the introductory phrases "one or more" or "at least one" and indefinite articles such as "a" or "an," e.g., "a" and/or "an" should be interpreted to mean "at least one" or "one or more;" the same holds true for the use of definite articles used to introduce claim recitations. In addition, even if a specific number of an introduced claim recitation is explicitly recited, those skilled in the art will recognize that such recitation should be interpreted to mean at least the recited number, e.g., the bare recitation of "two recitations," without other modifiers, means at least two recitations, or two or more recitations. Furthermore, in those instances where a convention analogous to "at least one of A, B, and C, etc." is used, in general such a construction is intended in the sense one having skill in the art would understand the convention, e.g., "a system having at least one of A, B, and C" would include but not be limited to systems that have A alone, B alone, C alone, A and B together, A and C together, B and C together, and/or A, B, and C together, etc. In those instances where a convention analogous to "at least one of A, B, or C, etc." is used, in general such a construction is intended in the sense one having skill in the art would understand the convention, e.g., "a system having at least one of A, B, or C" would include but not be limited to systems that have A alone, B alone, C alone, A and B together, A and C together, B and C together, and/or A, B, and C together, etc. It will be further understood by those within the art that virtually any disjunctive word and/or phrase presenting two or more alternative terms, whether in the description, claims, or drawings, should be understood to contemplate the possibilities of including one of the terms, either of the terms, or both terms. For example, the phrase "A or B" will be understood to include the possibilities of "A" or "B" or "A and B."

From the foregoing, it will be appreciated that various implementations of the present disclosure have been described herein for purposes of illustration, and that various modifications may be made without departing from the scope and spirit of the present disclosure. Accordingly, the various implementations disclosed herein are not intended to be limiting, with the true scope and spirit being indicated by the following claims.

**Claims**

1. A wireless communication method, comprising:

   selecting, by a processor of an apparatus, a codeword length based at least in part on a number of available bits associated with a data portion in a physical-layer protocol data unit (PPDU);
   generating, by the processor, the PPDU by performing low-density parity-check (LDPC) coding with the selected codeword length; and
   transmitting, by the processor, the PPDU in a wireless communication.

2. The wireless communication method of Claim 1, wherein the step of selecting comprises selecting the codeword length also based on whether a 2xLDPC subfield in the PPDU is set to 0 or 1, wherein 2xLDPC subfield set to be 1 means that a 2xLDPC mode is enabled for the PPDU.

3. The wireless communication method of Claim 2, wherein the step of selecting comprises, responsive to the number of available bits being greater than 3888 and the 2xLDPC subfield being set to 1, selecting the codeword length to be 3888.

4. The wireless communication method of Claim 2, wherein the step of selecting comprises, responsive to the number of available bits being greater than 3888 and the 2xLDPC subfield being set to 0, selecting the codeword length to be 1944.

5. The wireless communication method of Claim 2, wherein the step of selecting comprises, responsive to the number of available bits being less than or equal to 3888 and greater than 2592, selecting the codeword length to be 1944.

6. The wireless communication method of Claim 1, wherein information in a physical-layer (PHY) capabilities information field of the PPDU indicates the apparatus supports use of 2x1944 LDPC in performing LDPC encoding when the apparatus acts as a transmitter.

7. The wireless communication method of Claim 1, wherein information in a physical-layer (PHY) capabilities information field of the PPDU indicates the apparatus supports use of 2x1944 LDPC in performing LDPC decoding when the apparatus acts as a receiver.

8. The wireless communication method of Claim 1, wherein information in a physical-layer (PHY) capabilities information field of the PPDU indicates the apparatus supports use of 2x1944 LDPC in performing LDPC coding when the apparatus acts as a transmitter and supports use of 2x1944 LDPC in performing LDPC decoding when the apparatus acts as a receiver.

9. The wireless communication method of Claim 1, wherein an extra bit added in a User Specific field of the PPDU indicates whether a 2xLDPC mode is enabled or disabled.

10. The wireless communication method of Claim 9, wherein the extra bit is bit 22 (B22) in the User Specific field.

11. The wireless communication method of Claim 1, wherein either:

   a Nominal Packet Padding in the PPDU is fixed to 20us when the selected LDPC codeword length is 3888 and the 2xLDPC subfield in the PPDU is set to 1; or
   a PE (Packet Extension) field duration (T_PE) in the PPDU is fixed to 20us when the selected LDPC codeword length is 3888 and the 2xLDPC subfield in the PPDU is set to 1.

12. A wireless communication apparatus, comprising:

   a transceiver configured to communicate wirelessly; and
   a processor coupled to the transceiver and configured to perform operations, wherein the operations comprising:

      selecting a codeword length based at least in part on a number of available bits associated with a data portion in a physical-layer protocol data unit (PPDU);
      generating the PPDU by performing low-density parity-check (LDPC) coding with the selected codeword length; and
      transmitting, via the transceiver, the PPDU in a wireless communication.

13. The wireless communication apparatus of Claim 12, wherein, in selecting, the processor is configured to select the codeword length also based on whether a 2xLDPC subfield in the PPDU is set to 0 or 1.

14. The wireless communication apparatus of Claim 13, wherein, in selecting, the processor is configured to select the codeword length to be 3888 responsive to the number of available bits being greater than 3888 and the 2xLDPC subfield being set to 1.

15. The wireless communication apparatus of Claim 13, wherein, in selecting, the processor is configured to select the codeword length to be 1944 responsive to the number of available bits being greater than 3888 and the 2xLDPC subfield being set to 0.

100

STA
110

STA
120

WIRELESS COMMUNICATIONS WITH METHODS THAT ENABLE AND SIGNAL 2x1944 LOW-
DENSITY PARITY-CHECK (LDPC) CODES

# FIG. 1

200 ⟍

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld} + 912 \times (1\text{-}R)$ <br> 648, otherwise |
| $648 < N_{avbits} \leq 1296$ | 1 | 1944, if $N_{avbits} \geq N_{pld} + 1464 \times (1\text{-}R)$ <br> 1296, otherwise |
| $1296 < N_{avbits} \leq 1944$ | 1 | 1944 |
| $1944 < N_{avbits} \leq 2592$ | 1 | 2x1944, if $N_{avbits} \geq N_{pld} + 2916 \times (1\text{-}R)$ & if 2xLDPC is enabled, otherwise |
| | 2 | 1944, if $N_{avbits} \geq Npld + 2916 \times (1\text{-}R)$ <br> 1296, otherwise |
| $2592 < N_{avbits}$ | $\left\lceil \dfrac{N_{pld}}{L_{LDPC}*R} \right\rceil$ | $L_{LDPC}$=2x1944, if 2xLDPC is enabled <br> $L_{LDPC}$=1944 , Otherwise |

# FIG. 2

300 →

| Range of $N_{avbits}$ (bits) | Number of LDPC codewords ($N_{CW}$) | LDPC codeword length $L_{LDPC}$ (bits) |
|---|---|---|
| $N_{avbits} \le 648$ | 1 | 1296, if $N_{avbits} \ge N_{pld} + 912 \times (1\text{-}R)$<br>648, otherwise |
| $648 < N_{avbits} \le 1296$ | 1 | 1944, if $N_{avbits} \ge N_{pld} + 1464 \times (1\text{-}R)$<br>1296, otherwise |
| $1296 < N_{avbits} \le 1944$ | 1 | 1944 |
| $1944 < N_{avbits} \le 2592$ | 2 | 1944, if $N_{avbits} \ge N_{pld} + 2916 \times (1\text{-}R)$<br>1296, otherwise |
| $2592 < N_{avbits}$ | $\left\lceil \dfrac{N_{pld}}{L_{LDPC}*R} \right\rceil$ | $L_{LDPC}=2\times1944$, if 2xLDPC is enabled<br>$L_{LDPC}=1944$, Otherwise |

# FIG. 3

400

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld}+ 912 \times (1\text{-}R)$<br>648, otherwise |
| $648 < N_{avbits} \leq 1296$ | 1 | 1944, if $N_{avbits} \geq N_{pld}+ 1464 \times (1\text{-}R)$<br>1296, otherwise |
| $1296 < N_{avbits} \leq 1944$ | 1 | 1944 |
| $1944 < Navbits \leq 2592$ | 2 | 1944, if $N_{avbits} \geq Npld+ 2916 \times (1\text{-}R)$<br>1296, otherwise |
| $2592 < N_{avbits} <=3888$ | 2 | $L_{LDPC}=1944$ |
| $3888 < N_{avbits}$ | $\left\lceil \dfrac{N_{pld}}{L_{LDPC}*R} \right\rceil$ | $L_{LDPC}=2\times1944$, if 2xLDPC subfield in User Info field of the Trigger frame or in the User field of the UHR-SIG is set to 1<br>$L_{LDPC}=1944$, Otherwise |

# FIG. 4

500

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld} + 912 \times (1\text{-}R)$ <br> 648, otherwise |
| $648 < N_{avbits} \leq 1296$ | 1 | 1944, if $N_{avbits} \geq N_{pld} + 1464 \times (1\text{-}R)$ <br> 1296, otherwise |
| $1296 < N_{avbits} \leq 1944$ | 1 | 1944 |
| $1944 < Navbits \leq 2592$ | 2 | 1944, if $N_{avbits} \geq Npld + 2916 \times (1\text{-}R)$ <br> 1296, otherwise |
| $2592 < N_{avbits} <= 5184$ | $\left\lceil \dfrac{N_{pld}}{1944*R} \right\rceil$ | $L_{LDPC} = 1944$ |
| $5184 < N_{avbits}$ | $\left\lceil \dfrac{N_{pld}}{L_{LDPC}*R} \right\rceil$ | $L_{LDPC} = 2 \times 1944$, if 2xLDPC is enabled <br> $L_{LDPC} = 1944$, Otherwise |

# FIG. 5

600

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld} + 912 \times (1-R)$<br>648, otherwise |
| $648 < N_{avbits} \leq 1296$ | 1 | 1944, if $N_{avbits} \geq N_{pld} + 1464 \times (1-R)$<br>1296, otherwise |
| $1296 < N_{avbits} \leq 1944$ | 1 | 1944 |
| $1944 < Navbits \leq 2592$ | 2 | 1944, if $N_{avbits} \geq Npld + 2916 \times (1-R)$<br>1296, otherwise |
| $2592 < N_{avbits} <=TBD$ | $\left\lceil \dfrac{N_{pld}}{1944*R} \right\rceil$ | $L_{LDPC}=1944$ |
| $TBD < N_{avbits}$ | $\left\lceil \dfrac{N_{pld}}{L_{LDPC}*R} \right\rceil$ | $L_{LDPC}=2\times1944$, if 2xLDPC is enabled<br>$L_{LDPC}=1944$, Otherwise |

# FIG. 6

700

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld} + 912 \times (1-R)$ <br> 648, otherwise |
| $648 < N_{avbits} \leq 1296$ | 1 | 1944, if $N_{avbits} \geq N_{pld} + 1464 \times (1-R)$ <br> 1296, otherwise |
| $1296 < N_{avbits} \leq 1944$ | 1 | 1944 |
| $1944 < Navbits \leq 2592$ | 2 | 1944, if $N_{avbits} \geq Npld + 2916 \times (1-R)$ <br> 1296, otherwise |
| $2592 < N_{avbits} <= 3888$ | $\left\lceil \dfrac{N_{pld}}{1944*R} \right\rceil$ | $L_{LDPC} = 1944$ |
| $3888 < N_{avbits}$ | $\left\lceil \dfrac{N_{pld}}{3888*R} \right\rceil$ | $L_{LDPC} = 2*1944$ |

# FIG. 7

800

| Range of $N_{avbits}$ (bits) | Number of LDPC codewords $(N_{CW})$ | LDPC codeword length $L_{LDPC}$ (bits) |
|---|---|---|
| $N_{avbits} \leq 648$ | 1 | 1296, if $N_{avbits} \geq N_{pld} + 912 \times (1-R)$<br>648, otherwise |
| $648 < N_{avbits} \leq 1296$ | 1 | 1944, if $N_{avbits} \geq N_{pld} + 1464 \times (1-R)$<br>1296, otherwise |
| $1296 < N_{avbits} \leq 1944$ | 1 | 1944 |
| $1944 < Navbits \leq 2592$ | 2 | 1944, if $N_{avbits} \geq Npld + 2916 \times (1-R)$<br>1296, otherwise |
| $2592 < N_{avbits} <= 5184$ | $\left\lceil \dfrac{N_{pld}}{1944*R} \right\rceil$ | $L_{LDPC}=1944$ |
| $5184 < N_{avbits}$ | $\left\lceil \dfrac{N_{pld}}{3888*R} \right\rceil$ | $L_{LDPC}=2*1944$ |

# FIG. 8

900

| Range of $N_{avbits}$ (bits) | Number of LDPC codewords ($N_{CW}$) | LDPC codeword length $L_{LDPC}$ (bits) |
|---|---|---|
| $N_{avbits} \leq 648$ | 1 | 1296, if $N_{avbits} \geq N_{pld} + 912 \times (1-R)$ <br> 648, otherwise |
| $648 < N_{avbits} \leq 1296$ | 1 | 1944, if $N_{avbits} \geq N_{pld} + 1464 \times (1-R)$ <br> 1296, otherwise |
| $1296 < N_{avbits} \leq 1944$ | 1 | 1944 |
| $1944 < Navbits \leq 2592$ | 2 | 1944, if $N_{avbits} \geq Npld + 2916 \times (1-R)$ <br> 1296, otherwise |
| $2592 < N_{avbits} <= TBD$ | $\left\lceil \dfrac{N_{pld}}{1944 * R} \right\rceil$ | $L_{LDPC} = 1944$ |
| $TBD < N_{avbits}$ | $\left\lceil \dfrac{N_{pld}}{3888 * R} \right\rceil$ | $L_{LDPC} = 2 * 1944$ |

# FIG. 9

**MU PPDU**

Non-MU-MIMO

| | B0-B10 | B11-B14 | B15 | B16-B19 | B20 | B21 | B22 |
|---|---|---|---|---|---|---|---|
| | STD-ID | MCS | Resvd | Nss | Bfed | Coding | rsvd |
| Bits | 11 | 4 | 1 | 4 | 1 | 1 | 1 |

MU-MIMO

| | B0-B10 | B11-B14 | B15 | B16 | B17-B22 |
|---|---|---|---|---|---|
| | STD-ID | MCS | New add | Coding | SS Cfg |
| Bits | 11 | 4 | 1 | 1 | 6 |

Repurpose the meaning to indicate LDPC mode when RU/MRUU>=484; e.g. 0 for 1xLDPC; 1 for 2xLDPC

**UL TB PPDU**

| | B0 B11 | B12 B19 | B20 | B21 B24 | B25 | B26 B31 | B32 B38 | B39 | |
|---|---|---|---|---|---|---|---|---|---|
| | AID12 | RU Allocation | UL FEC Coding Type | UL EHT-MCS | Reserved | SS Allocation | UL Target Receive Power | PS160 | Trigger Dependent User Info |
| Bits: | 12 | 8 | 1 | 4 | 1 | 6 | 7 | 1 | variable |

1000

# FIG. 10

1100

**MU PPDU**

Non-MU-MIMO

| B0-B10 | B11-B14 | B15 | B16-B19 | B20 | B21 | B22 |
|--------|---------|------|---------|------|--------|--------|
| STD-ID | MCS | Resvd | Nss | Bfed | Coding | 2xLDPC |

Bits: 11, 4, 1, 4, 1, 1, 1

MU-MIMO

| B0-B10 | B11-B15 | B16-B19 | B20 | B21 | B22 |
|--------|---------|---------|----------|--------|------|
| STD-ID | MCS | SS Cfg | Reserved | Coding | 2xLDPC |

Bits: 11, 5, 4, 1, 1, 1

1 extra bit to indicate LDPC mode
e.g. 0 for 1xLDPC; 1 for 2xLDPC

**UL TB PPDU**

| B0 | B1 B12 | B19 B20 | B25 B26 | B27 B31 B32 | B38 B39 | | |
|-----|-----|-----|-----|-----|-----|-----|-----|
| AID12 | RU Allocation | UL FEC Coding Type | UL EHT-MCS | 2xLDPC | SS Allocation | UL Target Receive Power | PS160 | Trigger Dependent User Info |

Bits: 12, 8, 1, 5, 1, 5, 7, 1, variable

# FIG. 11

1200

APPARATUS
1210

PROCESSOR 1212

MEMORY
1214

TRANSCEIVER
1216

APPARATUS
1220

PROCESSOR 1222

TRANSCEIVER
1226

MEMORY
1224

# FIG. 12

1300 ⟍

Select, by a processor of an apparatus, a codeword length based at least in part on a number of available bits used in a data portion in a physical-layer protocol data unit (PPDU)

1310

Generate, by the processor, the PPDU by performing low-density parity-check (LDPC) coding with the selected codeword length

1320

Transmit, by the processor, the PPDU in a wireless communication

1330

# FIG. 13

## EUROPEAN SEARCH REPORT

**Application Number**

EP 25 17 5063

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/048271 A1 (FANG JUAN [US] ET AL) 8 February 2024 (2024-02-08) | 1,5,12 | **INV.** H03M13/00 |
| Y | * cf. passages cited in search opinion * | 2-4, 6-11, 13-15 | H04L1/00 |
| | ----- | | **ADD.** H03M13/11 |
| Y | US 2024/089030 A1 (LI QINGHUA [US] ET AL) 14 March 2024 (2024-03-14) | 2-4, 6-11, 13-15 | H03M13/25 |
| | * cf. passages cited in search opinion * ----- | | |
| X | 802 11 WORKING GROUP OF THE LAN/MAN STANDARDS COMMITTEE OF THE IEEE COMPUTER SOCIETY: "Specific Requirements Part 11: Wireless LAN Medium Access Control (MAC) and Physical Layer (PHY) Specifications", IEEE DRAFT; DRAFT P802.11REVME_D4.0 REDLINE COMPARED TO D3.1, IEEE-SA, PISCATAWAY, NJ USA , no. D4.0 10 August 2023 (2023-08-10), pages 1-5884, XP068202830, Retrieved from the Internet: URL:https://grouper.ieee.org/groups/802/11/private/Draft_Standards/11me/Draft%20P802.11REVme_D4.0%20Redline%20Compared%20to%20D3.1.pdf [retrieved on 2023-08-10] | 1,12 | **TECHNICAL FIELDS SEARCHED (IPC)** H03M H04L |
| A | * section 19.3.11.7.5, p.3285-3288 * | 2-11, 13-15 | |
| | ----- -/-- | | |

The present search report has been drawn up for all claims

| Place of search | Date of completion of the search | Examiner |
|---|---|---|
| Munich | 4 September 2025 | Wu, Zifeng |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 25 17 5063

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | STEVE SHELLHAMMER (QUALCOMM): "PDT EHT PHY Capabilities Information Field", IEEE DRAFT; 11-21-0224-00-00BE-PDT-EHT-PHY-CAPABILITIES-INFORMATION-FIELD, IEEE-SA MENTOR, PISCATAWAY, NJ USA , vol. 802.11 EHT; 802.11be 6 February 2021 (2021-02-06), pages 1-23, XP068176171, Retrieved from the Internet: URL:https://mentor.ieee.org/802.11/dcn/21/11-21-0224-00-00be-pdt-eht-phy-capabilities-information-field.docx [retrieved on 2021-02-06] * the whole document * | 1-15 | |
| | ----- | | |
| A | TIANYU WU (APPLE): "Minutes for TGbe PHY Ad-Hoc CC Nov 2020 to Jan 2021", IEEE DRAFT; 11-20-1767-06-00BE-MINUTES-FOR-TGBE-PHY-AD-HOC-CC-NOV-2020-TO-JAN-2021, IEEE-SA MENTOR, PISCATAWAY, NJ USA , vol. 802.11 EHT; 802.11be, no. 6 15 December 2020 (2020-12-15), pages 1-51, XP068175493, Retrieved from the Internet: URL:https://mentor.ieee.org/802.11/dcn/20/11-20-1767-06-00be-minutes-for-tgbe-phy-ad-hoc-cc-nov-2020-to-jan-2021.docx [retrieved on 2020-12-15] * the whole document * | 1-15 | TECHNICAL FIELDS SEARCHED (IPC) |
| | ----- | | |

The present search report has been drawn up for all claims

| Place of search | Date of completion of the search | Examiner |
|---|---|---|
| Munich | 4 September 2025 | Wu, Zifeng |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

................................................................................................

& : member of the same patent family, corresponding
  document

EPO FORM 1503 03.82 (P4C01)

**EP 4 648 294 A1**

## ANNEX TO THE EUROPEAN SEARCH REPORT
## ON EUROPEAN PATENT APPLICATION NO.

EP 25 17 5063

04-09-2025

| Patent document cited in search report | Publication date | Patent family member(s) | Publication date |
|---|---|---|---|
| US 2024048271 A1 | 08-02-2024 | EP 4542864 A1<br>US 2024048271 A1 | 23-04-2025<br>08-02-2024 |
| US 2024089030 A1 | 14-03-2024 | CN 119865280 A<br>US 2024089030 A1 | 22-04-2025<br>14-03-2024 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63643972